# EUROPÄISCHE PATENTSCHRIFT

(11) **EP 1 763 592 B1**
(45) Veröffentlichungstag und Bekanntmachung des Hinweises auf die Patenterteilung: **02.02.2011**
(21) Anmeldenummer: 05749696.0
(22) Anmeldetag: 26.04.2005
(51) Int. Cl.: C23C 14/06, C23C 14/32, H05H 1/48

(54) **BEFESTIGUNGSEINHEIT FÜR ZÜNDEINHEITEN UND VORRICHTUNG ZUR KOHLENSTOFFABSCHEIDUNG**
FASTENING UNIT FOR IGNITION UNITS, AND DEVICE FOR ELIMINATING CARBON
UNITE DE FIXATION POUR UNITES D'ALLUMAGE ET DISPOSITIF POUR LA SEPARATION DU CARBONE

(30) Priorität: 18.06.2004 DE 102004029525
(43) Veröffentlichungstag der Anmeldung: 21.03.2007
(73) Patentinhaber: ROBERT BOSCH GMBH, 70442 Stuttgart (DE)
(72) Erfinder: SCHNEIDER, Günter, 74354 Besigheim (DE); SCHATTKE, Alexander, 70499 Stuttgart (DE); FEUERFEIL, Rainer, 70839 Gerlingen (DE)
(86) Internationale Anmeldenummer: PCT/EP2005/051854
(87) Internationale Veröffentlichungsnummer: WO 2005/123977

(56) Entgegenhaltungen:
- EP-A- 0 462 303
- DE-A1- 3 516 598
- RU-C1- 2 153 782
- US-A- 4 919 968
- US-B1- 6 289 593

## Beschreibung

### Stand der Technik

Die Erfindung betrifft eine Befestigungseinheit für eine Zündeinheit und eine Vorrichtung zur Kohlenstoffabscheidung.

Zur Beschichtung von Werkstücken, insbesondere von tribologisch hochbelasteten Komponenten, die gleichzeitig einer zusätzlichen, mehrfachartigen Belastung wie beispielsweise der Temperatur oder der Kavitation0 unterliegen, sind mehrere physikalische Abscheidungsverfahren bekannt. Aus dem Bereich der Plasmabeschichtungstechnik sind zwei unterschiedliche Verfahren zur Erzeugung von metall- und wasserstofffreien Kohlenstoffschichten (sog. Tetraedrisch koordinierter amorpher Kohlenstoff, ta-C) zu nennen: Abscheidung von Graphittargets durch Sputtern oder durch Bogenverdampfung.

Das Sputter-Verfahren zeichnet sich jedoch durch eine niedrige Depositionsrate aus, weshalb dieses Verfahren für eine wirtschaftliche Nutzung nicht geeignet ist.

Bei einer Bogenverdampfung wird typischerweise das zu verdampfende Material auf kathodisches Potential gelegt, während als Anode eine spezielle Elektrode vorhanden ist oder auch die Wand der Beschichtungskammer als Anode dienen kann. Zum Verdampfen des Targetmaterials wird zwischen der Anode und der Kathode ein Lichtbogen gezündet, der die Kathode lokal an dem Brennpunkt, erkennbar an einem Brennfleck auf der Kathode, so stark aufheizt, dass das Targetmaterial in die Dampfphase übergeht und auf einem Werkstück abscheidet. Zur Erzeugung des Lichtbogens zwischen der Anode und der Kathode benötigt man eine Zündvorrichtung.

Neben beweglichen Zündvorrichtungen sind fest in der Nähe der Targetkathode angeordnete Zündelektroden bekannt, zwischen denen ein Lichtbogen gezündet wird, der dann von der Zündelektrode auf die Anode übergeht.

Eine kontrollierte dc-Bogenverdampfung von Kohlenstoff erweist sich als schwierig, da der Brennpunkt des Lichtbogens dazu tendiert, an einer Stelle des Targets fest- und möglicherweise durchzubrennen. Auch ist es bekannt, dass beim Verdampfen sogenannte Droplets (Makropartikeln) zu einer erhöhten Schichtrauheit auf dem Werkstück führen. Auch dieses Verfahren wird daher nur eingeschränkt eingesetzt.

Bei einer gepulsten Bogenentladung hingegen wird die Spannung zwischen der Anode und der Kathode pulsierend angelegt, wodurch der Brennpunkt auf dem Target gegenüber der dc-Bogenverdampfung auf ca. 100fache Geschwindigkeit beschleunigt und dadurch das Festbrennen vermieden wird. Die gepulste Bogenentladung hat im allgemeinen eine Pulslänge im Bereich von Millisekunden (msec), dadurch ist die Entladung in der räumlichen Nähe der Zündung lokalisiert.

Will man die Technologie der gepulsten Bogenentladung bei großflächigen Targets einsetzen, ist daher ein Aufbau mit mehreren einzelnen Zündquellen sinnvoll.

Aus der RU 2153782 C1 ist eine Kohlenstoffplasma-Impulsquelle zum Auftragen einer Kohlenstoffschicht auf ein Werkstück bekannt, die unter anderem eine Graphitkathode, eine Anode, eine kapazitive Speicherschaltung und mindestens zwei am Umfang der Graphitkathode angeordnete Zündeinheiten aufweist. Durch diese Anordnung wird im Vergleich zu einer Vorrichtung mit nur einer Zündeinheit der mit der Kohlenstoffschicht beschichtete Bereich erweitert und gleichzeitig die Dicke der aufgebrachten Schicht am Werkstück gleichmäßiger. Die Zündeinheiten bestehen jeweils aus einer stabförmigen Metallelektrode und aus einer ringförmigen Graphitelektrode, die jeweils als Zündkathode bzw. Zündanode dienen. Zwischen der Zündkathode und der Zündanode ist ein Ring aus einem dielektrischen Material angeordnet, wobei das dielektrische Material an der der Targetkathode zugewandten Seite mit einem elektrisch leitenden Material beschichtet ist. Die Längsachse jeder Zündeinheit ist dabei auf das entsprechende Gebiet der Arbeitsfläche der Targetkathode gerichtet, welches zum Starten der Lichtbogenentladung vorgesehen ist. Durch diese Anordnung ist die Zündeinheit mit der Stirnseite, an der die Zündung erfolgt, zur Targetkathode unter einem bestimmten Winkel geneigt.

Ist ein Austausch einer beispielsweise funktionsuntüchtigen Zündeinheit mit einer neuen Zündeinheit notwendig geworden, so ist es darauf zu achten, dass beim Einbau der neuen Zündeinheit die ursprüngliche Anordnung wiederhergestellt wird. Dazu gehört insbesondere auch die richtige Neigung der Zündeinheit gegenüber der Targetkathode unter einem vorgegebenen Winkel.

Aus der oben genannten Schrift geht jedoch nicht hervor, wie die erwünschte Neigung der Zündeinheit zu erreichen ist. Für die Praxis ist es wünschenswert, wenn die gewünschte Neigung der Zündeinheit einfach und schnell erreicht werden kann und vor allem eine erneute Justierung der Neigung nach einem Austausch der Zündeinheiten nicht notwendig wird. Aus der notwendigen Justierung der ausgetauschten Zündeinheiten resultiert ein hoher Zeit- und Wartungsaufwand im Betrieb der Beschichtungsanlage.

### Vorteile der Erfindung

Die erfindungsgemäße Befestigungseinheit für Zündeinheiten und die Vorrichtung zur Kohlenstoffabscheidung hat den Vorteil, dass ein einfacher Austausch der Zündeinheiten ermöglicht wird, ohne dabei die vorgesehene Neigung der neu eingebauten Zündeinheit justieren zu müssen. Ein Einbau einer Zündeinheit mittels der erfindungsgemäßen Befestigungseinheit führt automatisch zu der vorgegebenen Neigung der Zündeinheit gegenüber der Targetkathode der Beschichtungsanlage. Durch eine einfache Handhabung der Befestigungseinheit wird zudem ein schneller Austausch auch mehrerer Zündeinheiten ermöglicht. Weiter ist ein zusätzlicher Aufwand für wie etwa Wartung oder Kontrolle der Befestigungseinheit praktisch nicht notwendig.

Vorteilhafte Weiterbildungen der erfindungsgemäßen Befestigungseinheit und Vorrichtung sind in den Unteransprüchen angegeben und in der Beschreibung beschrieben.

### Zeichnung

Ausführungsbeispiele der Erfindung werden anhand der Zeichnung und der nachfolgenden Beschreibung näher erläutert. Es zeigen:
Figur 1 eine Befestigungseinheit im Querschnitt,
Figur 2 eine Befestigungseinheit mit einer eingebauten Zündeinheit und einer Targetkathode im Querschnitt,
Figur 3 eine erste Zündeinheit in perspektivischer Darstellung,
Figur 4 eine zweite Zündeinheit in perspektivischer Darstellung,
Figur 5 eine Vorrichtung zur Kohlenstoffabscheidung mit ihren wesentlichen Komponenten, und
Figur 6 eine Targetkathode in Draufsicht mit einem Kühlwasserkreislauf, einer Basiselektrode und mehreren Zündeinheiten.

### Beschreibung der Ausführungsbeispiele

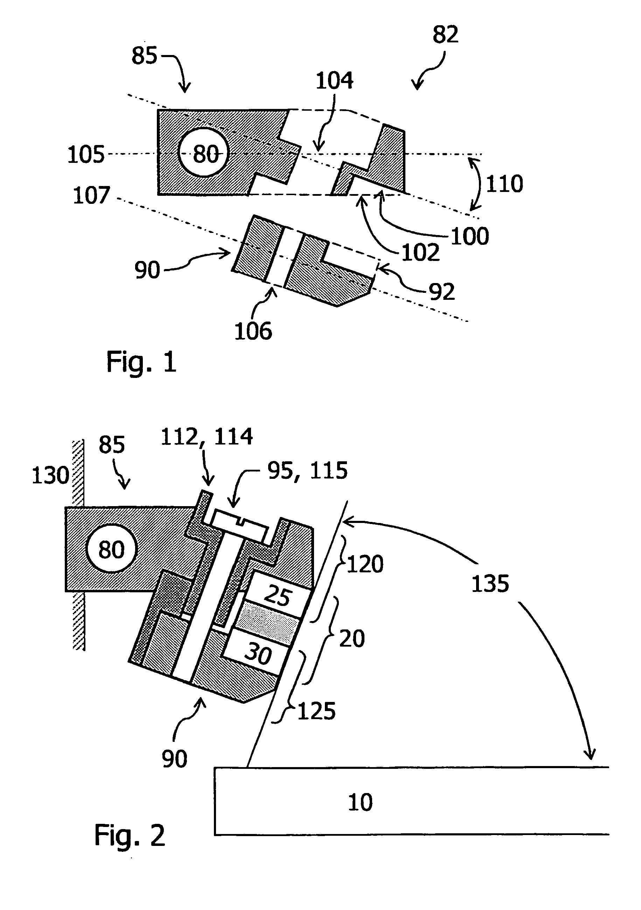

Die in Figur 1 im Querschnitt dargestellte Befestigungseinheit 82 für eine Zündeinheit, insbesondere einer Kohlenstoffabscheidevorrichtung, weist eine erste und eine zweite Halterung 85, 90 auf. Die beiden Halterungen 85, 90 werden, wie in Figur 2 dargestellt, durch ein Befestigungsmitte 95 zusammengehalten. Die Ausdehnung in der Länge ist für beide Halterungen 85, 90 größer als ihre jeweilige Ausdehnung in ihre Dicke. Entlang der Längenausdehnung der beiden Halterungen 85, 90 verlaufen, wie in Figur 1 dargestellt, die jeweiligen Längsachsen 105, 107. Die absolute Länge der ersten Halterung 85 ist typischerweise größer als die der zweiten Halterung 90.

Die erste Halterung 85 weist eine erste Bohrung 104 auf, die durchgehend durch die Dicke der Halterung 85 verläuft. Die Bohrung 104 ist abgestuft und hat einen mittleren Abschnitt mit einem kleineren Durchmesser. Die Bohrung 104 verläuft geneigt zur Oberfläche der Halterung 85 bzw. zur Längsachse 105. Ferner ist an einem Endbereich in der Längenausdehnung der Halterung 85 eine Ausnehmung 102 ausgebildet und zur zweiten Halterung 90 hin geöffnet. Dabei weist die Ausnehmung 102 eine derartige Form auf, dass durch die Ausnehmung 102 eine Wand auf der Unterseite der Halterung 85 ausgebildet wird, die im weiteren als Ebene 100 bezeichnet wird, die gegenüber der Längsachse 105 der ersten Halterung 85 einen ersten Winkel 110 zwischen 0° und 45° bildet. In diese Ausnehmung 102 kann eine Zündeinheit zumindest teilweise eingesetzt sein.

Die zweite Halterung 90 weist ebenfalls eine zweite Bohrung 106 und eine zweite Ausnehmung 92 auf. Die Bohrung 106 verläuft mit konstantem Durchmesser senkrecht zur Oberfläche der zweiten Halterung 90 bzw. zu ihrer Längsachse 107. Die Bohrung 106 kann durchgehend durch die Dicke der Halterung 90 verlaufen. Die Ausnehmung 92 ist an einem Endbereich in der Längenausdehnung der Halterung 90 ausgebildet und zur Ausnehmung 102 der ersten Halterung 85 geöffnet. Die Ausnehmung 92 weist eine Wand auf, die parallel zur Längsachse 107 der zweiten Halterung 90 verläuft. In diese Ausnehmung 92 kann die Zündeinheit zumindest teilweise eingesetzt sein.

Wie aus Figur 2 erkennbar, werden die beiden Halterungen 85, 90 durch ein Befestigungsmittel 95 zusammengehalten. Das Befestigungsmittel 95 ist bevorzugt eine Schraube 115. Für das Anbringen des Befestigungsmittel 95 sind die beiden Bohrungen 104, 106 vorgesehen. Typischerweise fluchten die Bohrungen 104, 106 miteinander. Dies kann beispielsweise dadurch erreicht werden, dass die Bohrung 104 der ersten Halterung 85 senkrecht zur Ebene 100 und die Bohrung 106 der zweiten Halterung 90 senkrecht zur Längsachse 107 der zweiten Halterung 90 verlaufen. Dann verlaufen die Bohrungen 104, 106 und die Stirnseite der Zündeinheit 20, an der die Zündung erfolgt, parallel zueinander. Auch sind mehrere Befestigungsmittel 95 für eine Befestigungseinheit 82 möglich, insbesondere zwei. Entsprechend steigt dann die Anzahl der Bohrungen 104, 106.

Die beiden Halterungen 85, 90 sind so angeordnet, dass die Ausnehmungen 102, 92 zueinander zugewandt sind. Die Zündeinheit 20 ist zwischen den beiden Halterungen 85, 90 angeordnet, wobei sie gleichzeitig in beide Ausnehmungen 102, 92 zumindest teilweise eingesetzt ist.

Weiter ist die Zündeinheit 20 so zwischen den beiden Halterungen 85, 90 angeordnet, dass die Stirnseite der Zündeinheit 20, an der die Zündung erfolgt, eine Senkrechte zu der Ebene 100 bildet. Da die Ebene 100 wie bereits geschildert gegenüber der Längsachse 105 der ersten Halterung 85 einen festen Winkel 110 zwischen 0° und 45° aufweist, führt diese Kombination immer zu einem festen Winkel zwischen 45° und 90° zwischen der Stirnseite der Zündeinheit 20 und der Längsachse 105 der ersten Halterung 85.

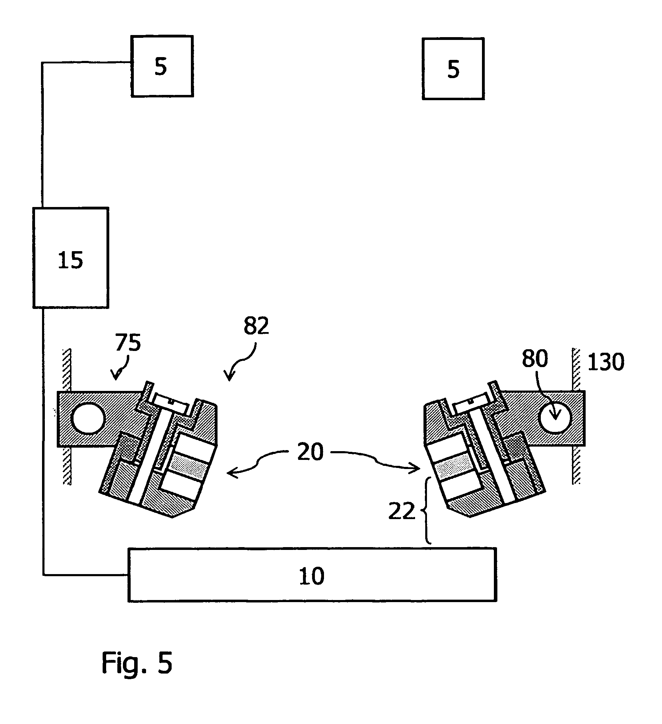

Bevorzugt ist die Befestigungseinheit 82 und eine Targetkathode 10 der Vorrichtung zur Kohlenstoffabscheidung, wie in Figur 5 dargestellt, so angeordnet, dass die Längsachse 105 der ersten Halterung 85 und die Oberfläche der Targetkathode 10 parallel zueinander verlaufen. Ein daraus resultierender zweiter Winkel 135 zwischen der Stirnseite der Zündeinheit 20 und der Oberfläche der Targetkathode 10 beträgt dann genau 90° vermindert um dem Wert des ersten Winkels 110. Ein geeigneter Wert des zweites Winkels 135 liegt insbesondere zwischen 45° und 90°.

Nach dem Lösen des Befestigungsmittels 95 kann die Zündeinheit 20 ausgetauscht werden. Die erste Halterung 85 ist fest mit einem Träger 130 der Vorrichtung zur Kohlenstoffabscheidung verbunden. Daher braucht die Anordnung und die relative Position der ersten Halterung 85 gegenüber der Targetkathode 10 nicht verändert zu werden. Nach einem einfachen Austausch der neuen Zündeinheit 20 werden anschließend die beiden Halterungen 85, 90 wieder durch das Befestigungsmittel 95 zusammengehalten, wobei durch die oben beschriebenen Merkmale der Befestigungseinheit 82 die gewünschte Neigung der Zündeinheit 20 ohne jegliche Justierung wieder erreicht wird.

Der Träger 130 der Vorrichtung zur Kohlenstoffabscheidung kann durch ein Gerüst innerhalb der Vakuumkammer ausgebildet sein oder ein Teil der Kammerwand sein.

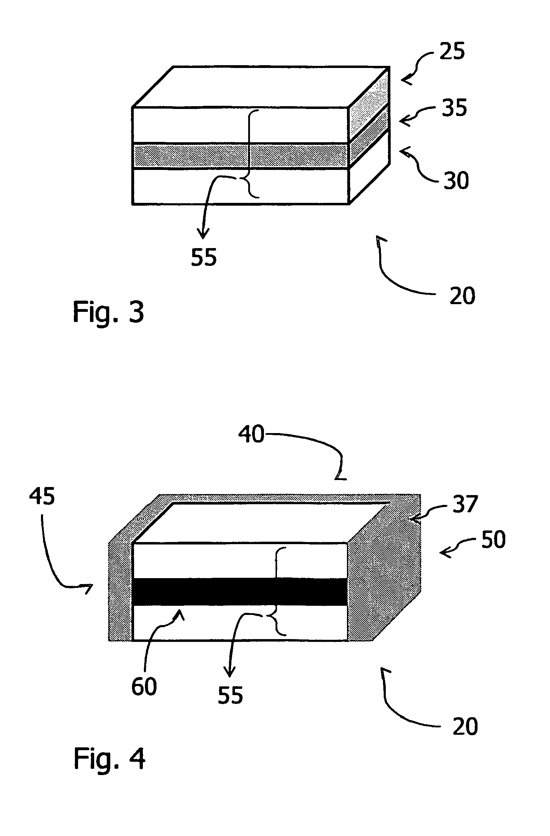

Bevorzugt werden planar ausgebildete Zündeinheiten 20 eingesetzt, da sich daraus weitere Vorteile der Erfindung ergeben. Wie in Figur 3 dargestellt, umfasst eine Zündeinheit 20 zwei planare, zueinander parallel angeordnete metallische Elektroden 25, 30, wobei im Zwischenraum zwischen den Elektroden 25, 30 eine planare Isolierkeramik 35 angeordnet ist. Die metallischen Elektroden 25, 30 können aus abbrandfesten Materialen wie beispielsweise Wolfram, Wolfram/Lanthan oder auch Graphit bestehen.

Eine zweite Ausführungsform der Zündeinheit 20 zeigt die Figur 4, bei der die Isolatorkeramik vorteilhafterweise zweiteilig aufgebildet ist. Der erste Teil wird, wie bereits beschrieben, durch eine planare Isolatorkeramik 35 gebildet. Der zweite Teil der Isolatorkeramik ist eine keramische Ummantelung 37, die sowohl die Rückseite 40 als auch die Seitenflächen 45, 50 der Zündeinheit 20 abdeckt. Dadurch wird sichergestellt, dass nur an der nicht mit der keramischen Ummantelung 37 abgedeckten Stirnseite 55 ein Zündfunke zwischen den zwei planaren Elektroden 25, 30 entsteht. Der erste und der zweite Teil der Isolatorkeramik können auch als ein zusammenhängendes Einzelteil ausgebildet sein.
Durch die planare Gestaltung der Zündeinheit 20 ergibt sich für die Isolierkeramik 35 auf der Oberfläche der Zündeinheit 20 eine linear ausgedehnte Struktur. In der Praxis beträgt ihre Länge etwa bis zu 10 cm. Zündet man die Zündeinheit 20 mehrere Male hintereinander, so entsteht der Zündfunke bei jeder erneuten Zündung statistisch verteilt an verschiedenen Stellen entlang der linear ausgedehnten Struktur. Somit wird auch der Brennpunkt auf der Targetkathode 10 bei jeder Zündung etwas versetzt. Auf eine einfache Weise wird eine homogene Ausnutzung der Gesamtfläche der Targetkathode 10 erzielt, die schließlich zu einer gleichmäßigen Beschichtung eines Werkstückes führt.

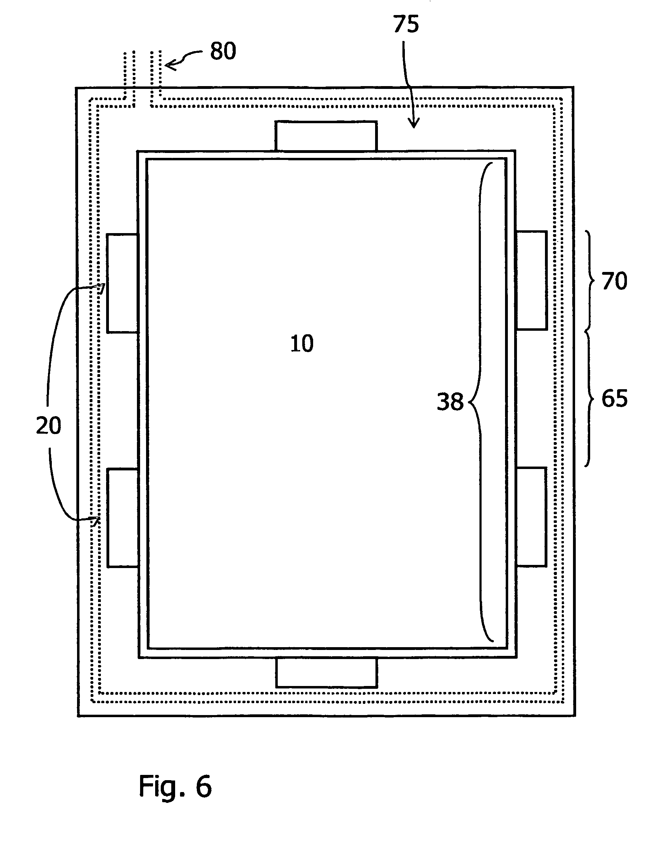

Ein weiteres Vorteil ergibt sich beim Vergleich der notwendigen Anzahl der planaren Zündeinheiten 20 gegenüber der Anzahl der nicht-planaren Zündeinheiten wie beispielsweise der rundförmigen Zündeinheiten. Hat die Targetkathode 10 in beiden Fällen die gleiche Länge 38 (siehe Figur 6), so sind weniger planare Zündeinheiten 20 notwendig, weil jede einzelne planare Zündeinheit 20 eine größere Fläche auf der Targetkathode 10 homogen abträgt. Eine kleinere Anzahl der Zündeinheiten 10 vermindert den Wartungsaufwand und verlängert die Standzeit.

Weiter können die planaren Zündeinheiten 20 aufgrund ihrer Form sehr nahe an der Targetkathode 10 positioniert werden, der Abstand 22 der Zündeinheit 20 zur Targetkathode 10 kann gegenüber einem Abstand einer nicht-planaren Zündeinheit zur Targetkathode 10 kleiner gewählt werden. Dadurch wird die Zündsicherheit deutlich erhöht und das Beschichtungsverfahren läuft insgesamt zuverlässiger.

Weiter ist in dieser Ausführungsform die Isolatorkeramik 35 der Zündeinheit 20 an der Stirnseite 55 mit einem elektrisch leitfähigen Material 60 beschichtet. Beim Anlegen eines Strompulses an der Zündeinheit 20 resultiert dann ein zur Targetkathode 10 gerichteter Strompfad, da teilweise die leitfähige Beschichtung der Isolatorkeramik 35 verdampft und ein hochionisiertes Plasma entsteht. Dieser aus Plasma gebildete Strompfad ermöglicht wiederum einen weiteren Strompfad zur eigentlichen Hauptentladung von der Targetkathode 10 zur Anode 5, wie in Figur 5 dargestellt. Der teilweise Verbrauch des leitfähigen Materials 60 auf der Isolatorkeramik 35 wird während der Hauptentladung durch eine erneute Beschichtung kompensiert und so der leitfähige Film regeneriert. Dieser Vorgang gewährleistet die Dauerstabilität der Zündeinheit 20 auch im Betrieb über eine längere Zeit.

Für eine zuverlässige Zündung sollte die Polung der Zündelektroden 25, 30 derart angelegt sein, dass eine maximale Potentialdifferenz zwischen der Zündeinheit 20 und der Kathode 10 erzeugt wird. Hierfür wird die der Targetkathode 10 näher angeordnete metallische Elektrode 30 als positiver, die der Targetkathode 10 entfernter angeordnete metallische Elektrode 25 als negativer Pol verwendet.

Durch eine günstige Anordnung der planaren Zündeinheiten 20 bezüglich der Targetkathode 10 lässt sich eine homogene Abtragung des Targetmaterials bzw. eine homogene Beschichtung eines Werkstückes noch weiter steigern. In Figur 6 ist eine Targetkathode 10 in Draufsicht dargestellt, wobei mehrere Zündeinheiten 20 am Rand der Targetkathode 10 angeordnet sind.

Um die Hauptentladung gleichmäßig verteilt an verschiedenen Orten der Targetfläche lokalisiert zu zünden, ordnet man mehrere Zündeinheiten 20 derart entlang des Targetrandbereichs an, dass die Gesamtwirkung der einzelnen Zündeinheiten 20 zu einer optimalen, d. h. homogenen Abtragung über den gesamten Bereich der Targetkathode 10 führt. Diese Vorgehensweise wird ermöglicht durch einen sowohl variierbaren Abstand 65 zwischen den Zündeinheiten 20 als auch durch die Wahlmöglichkeit, geeignete Zündeinheiten 20 mit variierender Länge 70 einsetzen zu können. Bisher bekannte, unerwünschte Randeffekte wie die abnehmende Schichtdicke der Beschichtung am oberen und unteren Bereich der Targetfläche können durch einen engeren Abstand 65 der Zündeinheiten 20 in den entsprechenden Bereichen ausgeglichen werden.

Figur 5 zeigt die Vorrichtung zur Kohlenstoffabscheidung mit ihren wesentlichen Komponenten. Die Vorrichtung zur Kohlenstoffabscheidung besteht im wesentlichen aus einer Anode 5, einer planaren Targetkathode 10, einer Pulsenergiequelle 15, einem Träger 130 für Befestigungseinheiten 82 und aus mindestens zwei Zündeinheiten 20 und Befestigungseinheiten 82. Die Zündeinheiten 20 sind im Randbereich der Targetkathode 10 angeordnet (siehe auch Figur 6). Die Zündeinheiten 20 sind elektrisch mit einem nicht dargestellten Zündverteiler verbunden, welcher die Zündung der einzelnen Zündeinheiten 20 steuert. Beim Anlegen eines Strompulses mit einer ausreichend hohen Spannung zwischen den beiden Elektroden 25, 30 entsteht eine Glimmentladung, mit dem die eigentliche Bogenentladung von der Targetkathode 10 zur Anode 5 entfacht wird.

Zwischen der aus Kohlenstoff gebildeten Targetkathode 10 und der Anode 5 ist die Pulsenergiequelle 15 geschaltet, die typischerweise mittels einer Kondensatorbank realisiert wird. Die Kondensatorbank wird über ein nicht dargestelltes Stromnetzteil gespeist und bleibt zunächst geladen, da zwischen der Anode 5 und der Targetkathode 10 ein Vakuum besteht und somit der Stromkreis nicht geschlossen ist. Zur Zündung eines Lichtbogens zwischen der Anode 5 und der Targetkathode 10 und damit zum Kohlenstoffabtrag von der Targetkathode 10 in Richtung zur Anode 5 sind mindestens zwei Zündeinheiten 20 vorgesehen.

Ein weiterer Vorteil der planaren Zündeinheiten 20 in Kombination mit der erfindungsgemäßen Befestigungseinheit ergibt sich aus der Möglichkeit, auf eine einfache Weise eine gemeinsame, durchgehende Basiselektrode 75 einzuführen.

Hierfür bestehen beiden Halterungen 85, 90 aus einem elektrisch leitfähigen Material, wobei das Befestigungsmittel 95 durch einen Isolierkörper 112, insbesondere eine keramische Isolierhülse 114, gegenüber mindestens einer Halterung 85, 90 elektrisch getrennt ist. Die elektrisch leitfähige Halterung 85, 90 bildet zusammen mit der kontaktierenden planaren Elektrode 25, 30 der Zündeinheit 20 eine gemeinsame Zündkathode 120 bzw. eine gemeinsame Zündanode 125. Mindestens zwei Zündeinheiten 20 weisen dann eine gemeinsame, durchgehende Basiselektrode 75 auf. Beispielsweise sind alle negativ gepolten Elektroden 25 der einzelnen Zündeinheiten 20 miteinander verbunden und somit elektrisch kontaktiert.

Solch eine gemeinsame, durchgehende Basiselektrode 75 bietet außerdem die Möglichkeit, einen Kühlwasserkreislauf 80 in die Basiselektrode 75 zu integrieren. Wie beispielsweise aus Figur 2 und Figur 6 erkennbar, weist die Basiselektrode 75 eine innere Leitung 80 auf, die als Kühlwasserleitung dient. Damit wird eine Kühlung aller Zündeinheiten 20 auf eine einfache Weise erzielt. Eine Kühlung der Zündeinheiten 20 ist für einen stabilen Dauerbetrieb deshalb erforderlich, weil die Zündeinheiten 20 einer hohen Wärmebelastung ausgesetzt sind, insbesondere bei hohen Zündfrequenzen.

## Patentansprüche

1. Befestigungseinheit für eine Zündeinheit (20), insbesondere einer Kohlenstoffabscheidevorrichtung, wobei
- die Zündeinheit (20) zwei metallische Elektroden (25, 30) umfasst, und wobei im Zwischenraum zwischen den Elektroden (25, 30) eine Isolatorkeramik (35) angeordnet ist,
- die Zündeinheit (20) zwischen einer ersten und einer zweiten Halterung (85, 90) angeordnet ist,
- die beiden Halterungen (85, 90) durch mindestens ein Befestigungsmittel (95) zusammengehalten werden,
- die erste Halterung (85) eine Ebene (100) aufweist, die gegenüber der Längsachse (105) der ersten Halterung (85) einen ersten Winkel (110) zwischen 0° und 45° aufweist, und
- die Stirnseite (55) der Zündeinheit (20), an der die Zündung erfolgt, senkrecht zu der Ebene (100) angeordnet ist.

2. Befestigungseinheit nach Anspruch 1,
**dadurch gekennzeichnet,**
**dass** die Ebene (100) ein Teil der Wand einer ersten Ausnehmung (102) in der ersten Halterung (85) ist, wobei in die Ausnehmung (102) die Zündeinheit (20) zumindest teilweise eingesetzt ist.

3. Befestigungseinheit nach Anspruch 1 oder 2,
**dadurch gekennzeichnet,**
**dass** die zweite Halterung (90) eine zweite Ausnehmung (92) aufweist, wobei in die Ausnehmung (92) die Zündeinheit (20) zumindest teilweise eingesetzt ist.

4. Befestigungseinheit nach einem der Ansprüche 1 bis 3,
**dadurch gekennzeichnet,**
**dass** die erste und die zweite Halterung (85, 90) jeweils eine Bohrung (104, 106) für das Anbringen des Befestigungsmittels (95) aufweisen.

5. Befestigungseinheit nach Anspruch 4,
**dadurch gekennzeichnet,**
**dass** die Bohrung (104) der ersten Halterung (85) und die Bohrun (106) der zweiten Halterung (90) miteinander fluchten.

6. Befestigungseinheit nach einem der Ansprüche 1 bis 5,
**dadurch gekennzeichnet,**
**dass** das Befestigungsmittel (95) eine Schraube (115) ist.

7. Befestigungseinheit nach einem der Ansprüche 1 bis 6,
**dadurch gekennzeichnet,**
**dass** beide Halterungen (85, 90) aus einem elektrisch leitfähige Material bestehen.

8. Befestigungseinheit nach einem der Ansprüche 1 bis 7,
**dadurch gekennzeichnet,**
**dass** das Befestigungsmittel (95) durch einen Isolierkörper (112 gegenüber mindestens einer Halterung (85, 90) elektrisch getrennt ist.

9. Befestigungseinheit nach Anspruch 8,
**dadurch gekennzeichnet,**
**dass** der Isolierkörper (112) eine keramische Isolierhülse (114) ist.

10. Vorrichtung zur Kohlenstoffabscheidung, insbesondere zur Abscheidung von tetraedrisch koordinierten amorphen Kohlenstoffschichten (ta-C), die eine Anode (5), eine aus Kohlenstoff bestehende Targetkathode (10), mindestens zwei Zündeinheiten (20) und Befestigungseinheiten (82) aufweist, wobei die Zündeinheiten (20) durch die Befestigungseinheiten (82) im Randbereich der Targetkathode (10) angeordnet sind, und mit der Stirnseite (55), an der die Zündung erfolgt, der Targetkathode (10) zugewandt sind,
**dadurch gekennzeichnet,**
**dass** eine Befestigungseinheit eine erste und eine zweite Halterung (85, 90) aufweist, wobei die beiden Halterungen (85, 90) durch mindestens ein Befestigungsmittel (95) zusammengehalten werden, und wobei die erste Halterung (85) fes mit einem Träger (130) der Vorrichtung verbunden ist, und zusammen mit der zweiten Halterung (90) die Zündeinheit (20) zwischen den beiden Halterungen (85, 90) so geneigt anordnet, dass die Stirnseite (55) der Zündeinheit (20) gegenüber der Targetkathode (10) einen Winkel (135) einschließt.

11. Vorrichtung nach Anspruch 10,
**dadurch gekennzeichnet,**
**dass** der Winkel (135) zwischen 45° und 90° beträgt.

12. Vorrichtung nach einem der Ansprüche 10 oder 11,
**dadurch gekennzeichnet,**
**dass** eine der beiden Halterungen (85, 90) zusammen mit der kontaktierenden Elektrode (25) der Zündeinheit (20) eine gemeinsame Zündkathode (120) bildet.

## Claims

1. Fastening unit for an ignition unit (20), in particular a carbon eliminating device wherein
- the ignition unit (20) comprises two metallic electrodes (25, 30), and wherein a ceramic insulator element (35) is arranged in the intermediate space between the electrodes (25, 30),
- the ignition unit (20) is arranged between a first and a second mount (85, 90),
- the two mounts (85, 90) are held together by at least one fastening means (95),
- the first mount (85) has a plane (100) which is at a first angle (110) between 0° and 45° with respect to the longitudinal axis (105) of the first mount (85), and
- the front side (55) of the ignition unit (20) at which the ignition takes place is arranged perpendicularly with respect to the plane (100).

2. Fastening unit according to Claim 1,
**characterized in that** the plane (100) is part of the wall of a first recess (102) in the first mount (85), wherein the ignition unit (20) is inserted at least partially into the recess (102).

3. Fastening unit according to Claim 1 or 2,
**characterized in that** the second mount (90) has a second recess (92) wherein the ignition unit (20) is at least partially inserted into the recess (92).

4. Fastening unit according to one of Claims 1 to 3,
**characterized in that** the first and the second mounts (85, 90) each have a drill hole (104, 106) for the attachment of the fastening means (95).

5. Fastening unit according to Claim 4,
**characterized in that** the drill hole (104) of the first mount (85) and the drill hole (106) of the second mount (90) are aligned with one another.

6. Fastening unit according to one of Claims 1 to 5,
**characterized in that** the fastening means (95) is a screw (115).

7. Fastening unit according to one of Claims 1 to 6,
**characterized in that** both mounts (85, 90) are composed of an electric conductive material.

8. Fastening unit according to one of Claims 1 to 7,
**characterized in that** the fastening means (95) is electrically isolated from at least one mount (85, 90) by means of an insulating body (112).

9. Fastening unit according to Claim 8,
**characterized in that** the insulating body (112) is a ceramic insulating sleeve (114).

10. Device for eliminating carbon, in particular for eliminating tetrahedrally coordinated amorphous carbon layers (ta-C), which has an anode (5), a target cathode (10) which is composed of carbon, at least two ignition units (20) and fastening units (82), wherein the ignition units (20) are arranged in the edge region of the target cathode (10) by means of the fastening unit (82) and face the target cathode (10) with their front side (55) at which the ignition takes place,
**characterized in that** a fastening unit has a first and a second mount (85, 90), wherein the two mounts (85, 90) are held together by at least one fastening means (95), and wherein the first mount (85) is permanently connected to a carrier (130) of the device, and together with the second mount (90) the ignition unit (20) is arranged inclined between the two mounts (85, 90) in such a way that the front side (55) of the ignition unit (20) encloses an angle (135) with respect to the target cathode (10).

11. Device according to Claim 10,
**characterized in that** the angle (135) is between 45° and 90°.

12. Device according to one of Claims 10 or 11,
**characterized in that** one of the two mounts (85, 90) forms a common ignition cathode (120) together with the contact-forming electrode (25) of the ignition unit (20).

## Revendications

1. Unité de fixation pour une unité d'allumage (20), notamment un dispositif séparateur de carbone,
- l'unité d'allumage (20) comprenant deux électrodes métalliques (25, 30) et une céramique isolante (35) étant disposée dans l'espace intermédiaire entre les électrodes (25, 30),
- l'unité d'allumage (20) étant disposée entre un premier et un deuxième support (85, 90),
- les deux supports (85, 90) étant maintenus ensemble par au moins un moyen de fixation (95),
- le premier support (85) présentant un plan (100) qui présente un premier angle (110) entre 0° et 45° par rapport à l'axe longitudinal (105) du premier support (85) et
- le côté frontal (55) de l'unité d'allumage (20), là où a lieu l'allumage, étant disposé perpendiculairement au plan (100).

2. Unité de fixation selon la revendication 1, **caractérisée en ce que** le plan (100) est une partie de la paroi d'un premier évidement (102) dans le premier support (85), l'unité d'allumage (20) étant au moins partiellement introduite dans l'évidement (102).

3. Unité de fixation selon la revendication 1 ou 2, **caractérisée en ce que** le deuxième support (90) présente un deuxième évidement (92), l'unité d'allumage (20) étant au moins partiellement introduite dans l'évidement (92).

4. Unité de fixation selon l'une des revendications 1 à 3, **caractérisée en ce que** le premier et le deuxième supports (85, 90) présentent respectivement un orifice (104, 106) pour le montage du moyen de fixation (95).

5. Unité de fixation selon la revendication 4, **caractérisée en ce que** l'orifice (104) du premier support (85) et l'orifice (106) du deuxième support (90) sont à fleur l'un de l'autre.

6. Unité de fixation selon l'une des revendications 1 à 5, **caractérisée en ce que** le moyen de fixation (95) est une vis (115).

7. Unité de fixation selon l'une des revendications 1 à 6, **caractérisée en ce que** les deux supports (85, 90) se composent d'un matériau électriquement conducteur.

8. Unité de fixation selon l'une des revendications 1 à 7, **caractérisée en ce que** le moyen de fixation (95) est isolé électriquement par rapport à au moins un support (85, 90) par un corps isolant (112).

9. Unité de fixation selon la revendication 8, **caractérisée en ce que** le corps isolant (112) est une douille isolante en céramique (114).

10. Dispositif de séparation de carbone, notamment pour séparer des couches de carbone à coordination tétraédrique amorphe (ta-C), qui présente une anode (5), une cathode cible (10) composée de carbone, au moins deux unités d'allumage (20) et des unités de fixation (82), les unités d'allumage (20) étant disposées par les unités de fixation (82) dans la zone de bordure de la cathode cible (10) et le côté frontal (55), là où a lieu l'allumage, étant dirigé vers la cathode cible (10),
**caractérisé en ce**
**qu'**une unité de fixation présente un premier et un deuxième supports (85, 90), les deux supports (85, 90) étant maintenus ensemble par au moins un moyen de fixation (95), et le premier support (85) étant relié à demeure avec un élément porteur (130) du dispositif et, conjointement avec le deuxième support (90), l'unité d'allumage (20) étant disposée inclinée entre les deux supports (85, 90) de telle sorte que le côté frontal (55) de l'unité d'allumage (20) inclut un angle (135) par rapport à la cathode cible (10).

11. Dispositif selon la revendication 10, **caractérisé en ce que** l'angle (135) est compris entre 45° et 90°.

12. Dispositif selon l'une des revendications 10 ou 11, **caractérisé en ce que** l'un des deux supports (85, 90), conjointement avec l'électrode de contact (25) de l'unité d'allumage (20), forme une cathode d'allumage commune (120).
